## Europäisches Patentamt

## European Patent Office

## Office européen des brevets

(19)

(11) Veröffentlichungsnummer: **0 111 222**
**B1**

(12) # EUROPÄISCHE PATENTSCHRIFT

(45) Veröffentlichungstag der Patentschrift:
08.03.89

(51) Int. Cl.⁴: **H 04 R 25/02,** H 05 K 3/30

(21) Anmeldenummer: **83111790.8**

(22) Anmeldetag: **24.11.83**

(54) **Kleinhörgerät.**

(30) Priorität: **06.12.82 DE 3245030**

(43) Veröffentlichungstag der Anmeldung:
**20.06.84 Patentblatt 84/25**

(45) Bekanntmachung des Hinweises auf die Patenterteilung:
**08.03.89 Patentblatt 89/10**

(84) Benannte Vertragsstaaten:
**AT CH DE FR GB IT LI NL**

(56) Entgegenhaltungen:
**DE-B-1 139 549**
**FR-A-2 271 740**
**GB-A-1 198 449**
**GB-A-2 000 336**
**US-A-2 959 645**

(73) Patentinhaber: **Siemens Aktiengesellschaft Berlin und München, Wittelsbacherplatz 2, D-8000 München 2 (DE)**

(72) Erfinder: **Henneberger, Hans, Holzleite 29, D-8521 Effeltrich (DE)**
Erfinder: **Puchta, Walter, Drausnickstrasse 120, D-8520 Erlangen (DE)**

## Beschreibung

Die Erfindung betrifft ein Kleinhörgerät nach dem Oberbegriff des Anspruchs I. Solche Geräte sind z. B. aus dem DE-GM-7 831 808 oder der DE-AS-1 139 549 vorbekannt.

Leiterplatten, bei denen Bauelemente, z. B. Scheibenkondensatoren, (allerdings nicht in Zusammenhang mit Hörgeräten) in engen Schlitzen einklemmbar sind, sind z. B. aus der US-PS-3 049 647 vorbekannt.

Durch die GB-A-1 198 449 sind außerdem außerhalb des Hörgerätegebiets Leiterplatten mit im wesentlichen rechteckförmigen Öffnungen zum Einsetzen der Bauelemente vorbekannt. Die eingesetzten Bauelemente werden aber entweder mit Gießharz in der jeweiligen Öffnung eingegossen oder sie schnappen in Vertiefungen ein, die in die Öffnungen eingearbeitet sind.

Durch die GB-A-2 000 336 (insbesondere Figuren 64, 66 und 67) ist schließlich ein Gehäuse für eine elektronische Uhr vorbekannt, das eine rechteckige Öffnung zum Einsetzen einer LCD-Anzeige sowie des zugehörigen elektronischen Steuerchips aufweist, wobei die Öffnung an zwei Ecken leicht abgeschnitten ist. Diese abgeschrägten Ecken haben keinen Bezug auf das in die Öffnung einzusetzende Bauelement. Dieses Bauelement, ein Steuerchip, wird durch Kontaktfüße auf Abstand zu den Wänden der Öffnung gehalten. Die eigentliche LCD-Anzeige, die über sogenannte Zebra-Leitungsverbindungsstücke mit den Kontaktfüßen des Steuerchips in Verbindung steht, ist hingegen in ihren äußeren Abmessungen exakt an die Kontur der Öffnung angepaßt. Toleranzschwankungen können nicht ausgeglichen werden.

Bei Kleinhörgeräten, insbesondere solchen, die am Kopf getragen werden, wie Im-Ohr-, Hinter-Ohr-Hörgeräten oder Hörbrillen, ist wegen der kleinen Abmessungen der Umfang der Einbauräume sehr beschränkt. Es wird daher immer nach Möglichkeiten gesucht, die zur Wandlung und Verstärkung etc. des Schalls notwendigen Einzelteile darin möglichst günstig und raumsparend unterzubringen.

Der Erfindung liegt die Aufgabe zugrunde, bei einem Kleinhörgerät nach dem Oberbegriff des Anspruchs 1 Anordnungen des Verstärkers anzugeben, die zu einem raumsparenden Aufbau führen. Diese Aufgabe wird erfindungsgemäß durch die Merkmale des Anspruchs 1 gelöst.

Die Erfindung geht davon aus, daß im Zuge der Zugänglichkeit kleinerer Bauelemente (Transistoren, Widerstände, Kondensatoren etc.) auch die Dicke von Trägerplatten (Leiterplatten, Dickschichtplatten etc.) interessant wird, weil unter Berücksichtigung der erforderlichen Stabilität keine beliebige Verringerung der Dicke dieser Trägerplatten möglich ist. Nach der Erfindung kann die Dicke von Trägerplatten für die Bauhöhe von Verstärkeranordnungen völlig außer Betracht bleiben, wenn die Bauelemente in der Trägerplatte versenkt untergebracht werden, etwa, indem in die Trägerplatte Öffnungen eingebracht werden, in welche die Körper der Bauelemente einsetzbar sind. Dadurch kommt man von der üblichen Berechnung, Dicke der Trägerplatte plus Dicke der Bauelemente ergibt die Gesamtbauhöhe des Verstärkers, weg. Bei an sich rechteckigen Bauelementen werden dabei die Ecken der Öffnungen zur seitlichen Halterung und Führung der Bauelemente benutzt, indem die Öffnungen die Form eines Rechtecks mit einer (bzw. mehreren) abgeschnittenen (z. B. 45) Ecke(n) erhalten. Dies hat den weiteren Vorteil, daß Toleranzen der Abmessungen einzusetzender Bauelemente ausgeglichen werden, indem die Ecken des Bauelements bei veränderten Seitenlängen an anderer Stelle der Schrägung angreifen. Dies ist an sich schon mit einer Öffnung erreichbar, die Rechteckform hat, bei der nur eine Ecke abgeschnitten ist. Durch die seitlich abstehenden Ansätze des Bauelementes, die von elektrischen Anschlüssen gebildet werden, wird vermieden, daß das Bauelement beim Einsetzen in die Trägerplatte durch die Öffnung fällt. Desweiteren wird das Bauelement über die mit den Leiterbahnen verbundenen Anschlüsse an der Trägerplatte gehaltert. Ferner ergibt sich zwischen der Öffnung der Trägerplatte und dem Bauelement eine bestimmte Zuordnung der Anschlüsse und eine Zentrierung des Bauelementes. Dies ist von Vorteil, weil das richtige Einsetzen der Bauelemente dann keine konzentrierte Aufmerksamkeit erfordert. Eine diesbezüglich günstige Form wird z. B. erreicht mit einer Öffnung, bei der zwei abgeschnittene Ecken vorhanden sind. Ein darin einzusetzendes rechteckiges Bauteil kommt mit seinem Zentrum immer an die gleiche Stelle.

Im Gegensatz zur Schlitzhalterung der US-PS-3 049 647 wird das Bauelement bei der Erfindung nicht durch zusätzliche Kraftausübung (wodurch das Bauelement beschädigt oder zerstört werden könnte) eingeklemmt, sondern es paßt sich selbsttätig ohne Bauelement- oder Öffnungsverformung positionsrichtig in das abgeschrägte Rechteck der Öffnung ein. Auch sehr druckempfindliche Bauelemente lassen sich damit einwandfrei selbsthaftend in Öffnungen der Trägerplatte versenken. Dasselbe gilt auch im Vergleich mit den Bauelementhalterungen der GB-A-1 198 449 und GB-A-2 000 336.

Weitere Einzelheiten und Vorteile der Erfindung werden nachfolgend anhand der in den Figuren dargestellten Ausführungsbeispiele weiter erläutert.

In der Figur 1 ist die Außenansicht eines HdO-Hörgerätes gezeichnet,

in der Figur 2 in vergrößertem Maßstab die untere Schale des Gerätes, in welcher die Bauteile des Hörgerätes eingesetzt sind,

in der Figur 3 die Einsetzung eines Bauelementes in eine Öffnung einer Verstärker-Trägerplatte und

in der Figur 4 die Halterung eines rechteckigen Bauelementes in einer Öffnung, die in Draufsicht die Form eines Rechteckes hat, dessen an einer langen Seite liegende Ecken abgeschnitten sind.

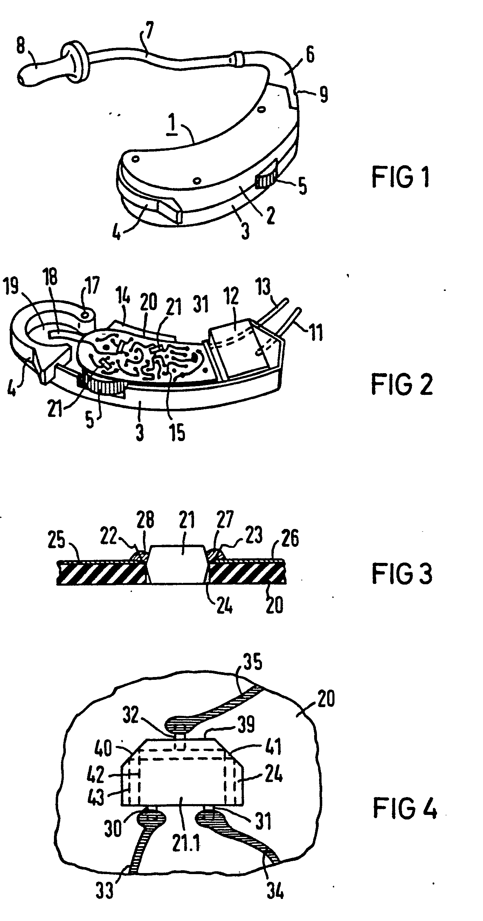

In der Figur 1 ist mit 1 ein hinter dem Ohr zu tragendes Hörgerät bezeichnet, dessen Einzelteile sich in einem aus einer Oberschale 2 und einer Unterschale 3 gebildeten Gehäuse befinden. An der Außenseite ragen aus dem Gerät ein Batteriehalter 4 und ein Lautstärkeregler 5 hervor. Zum Tragen am Ohr weist das Gehäuse an einem Ende einen Traghaken 6 auf, durch welchen eine Schalleitung geführt ist, die über einen Schlauch 7 mit einer Ohrolive 8 verbunden ist. Der Schall gelangt in das Gerät über eine Aufnahmeöffnung 9, die im Traghaken 6 liegt. Die Schallzuleitung setzt sich im Gehäuse durch einen Schallkanal 11 zum Mikrofon 12 fort, wie aus der Figur 2 ersichtlich ist. Dort ist auch ersichtlich, daß eine Schalleitung 13 von einem Hörer 14 zu der Leitung im Traghaken 6 führt. Zwischen dem Batteriehalter 4 und dem Mikrofon 12 liegt der Verstärkeraufbau 15. Die Stromversorgung des Verstärkeraufbaus 15 erfolgt vom Batteriehalter 4 aus, der an einer Achse 17 schwenkbar gelagert ist, so daß am Kontakt 18 eine in den Raum 19 eingelegte Batterie kontaktiert werden kann. Durch Schwenken des Halters 4 an der Achse 17 kann ein Lösen und Schließen des Anschlusses an dem Kontakt 18 zum Ausschalten und Einschalten des Gerätes benutzt werden.

Der Aufbau des Verstärkers weist eine Trägerplatte 20 auf. In diese Träger- oder Leiterplatte sind Bauelemente 21 und 21.1 eingesetzt. Das Bauelement 21 selbst weist von seiner Mitte aus, an welcher Anschlußdrähte 22 und 23 liegen, konische Form nach dem Rand zu auf, wie die nach beiden Seiten verlaufende keilförmige Form andeutet. Dadurch wird eine Verkeilung in der mit geraden Wänden versehenen Trägerplatte 20 erreicht. Das in der Öffnung 24 eingeklemmte Bauelement 21 wird schließlich an seinen Anschlußdrähten mit Leiterbahnen 25 und 26 verlötet, wie durch die Lötmittelanbringungen 27 und 28 angedeutet ist.

Bei dem in Figur 3 dargestellten Einsatz eines Bauelementes 21.1 hat die Öffnung die Form eines Rechteckes, dessen an einer langen Seite 39 liegende Ecken 40 und 41 abgeschnitten sind. Beim Einsetzen eines Bauelementes 21.1, das, wie im gezeichneten Fall, ein Transistor mit drei Anschlüssen 30, 31 und 32 sein kann, geraten seine oberen Ecken in Eingriff mit den Schrägungen der abgeschnittenen Ecken 40, 41. Die Anschlüsse 30 bis 32 können, wie zu Figur 3 angegeben, an Leiterbahnen 33, 34 und 35 angelötet werden. Bei Unregelmäßigkeiten der Kantenlängen wird immer eine Halterung erzielt, weil sich, wie durch gestrichelte bzw. strichpunktierte Eintragungen 42, 43 angedeutet, lediglich die Ansatzpunkte verschieben.

**Patentansprüche**

1. Kleinhörgerät mit einem Mikrofon, einem Verstärker, einer Stromquelle und einem Hörer, die in einem Gehäuse untergebracht sind, wobei die Bauelemente des Verstärkers an einer Trägerplatte in Öffungen versenkt angebracht sind, dadurch gekennzeichnet, daß eine Öffnung (24) zur Aufnahme eines rechteckigen Bauelementes (21, 21.1) die Form eines größeren Rechtecks hat, bei dem wenigstens eine Ecke (40, 41) abgeschnitten ist, daß sich das in die Öffnung eingesetzte Bauelement, abhängig von seinen toleranzbestimmten Seitenlängen, an unterschiedlicher Stelle der Schrägung der abgeschnittenen Ecke (40, 41) abstützt und daß das Bauelement seitlich abstehende, sein Durchschieben durch die Öffnung hindernde Ansätze in Form von elektrischen Anschlüssen (22, 23; 30, 31, 32) aufweist, die mit Leiterbahnen (25, 26; 33, 34, 35) der Trägerplatte (20) verbindbar sind.

2. Kleinhörgerät nach Anspruch 1, dadurch gekennzeichnet, daß zwei an einer langen Seite (39) der rechteckförmigen Öffnung (24) liegende Ecken (40, 41) abgeschnitten sind.

**Claims**

1. A small hearing aid apparatus having a microphone, an amplifier, a source of current and an ear piece that are accommodated in a housing, the component parts of the amplifier being sunk in openings on a carrier plate, characterised in that an opening (24) to receive a rectangular component part (21, 21.1) has the form of a larger rectangle from which at least one corner (60, 41) has been cut off, in that the component part inserted into the opening is supported at different points of the diagonal of the cut-off corners (40, 41), depending on the lengths of its sides that are determined by tolerances and in that the component part has lateral projections that prevent it from being pushed through the opening and are in the form of electrical connections (22, 23; 30, 31, 32) that can be connected to the conductor tracks (25, 26; 33, 34, 35) of the carrier plate (20).

2. A small hearing aid apparatus according to claim 1, characterised in that two corners (40, 41) are cut off on a long side (39) of the rectangular opening (24).

**Revendications**

1. Mini-appareil de correction auditive, comportant un microphone, un amplificateur, une source de courant et un écouteur, logés dans un boîtier, les composants de l'amplificateur étant montés sur une plaque de support, en position enfoncée dans des ouvertures, caractérisé par le fait qu'une ouverture (24) servant a recevoir un composant rectangulaire (21, 21.1), possède la forme d'un rectangle dont au moins un sommet (40, 41) est découpé, que le composant qui est introduit dans l'ouverture prend appui, en fonction des longueurs de ses côtés, qui dépendent de la tolérance, en un emplacement différent de la partie oblique du sommet découpé (40, 41), et que le composant possède, pour l'empêcher de passer à travers l'ouverture, des appendices saillant latéralement, de la forme de bornes électriques (22, 23; 30, 31, 32) qui sont susceptibles d'être reliées a des pistes conductrices (25, 26; 33, 34, 35) de la plaque de support (20).

2. Mini-appareil de correction auditive selon la revendication 1, caractérisé par le fait que deux sommets (40, 41) qui se situent sur un côté long (39) de l'ouverture (24) de la forme d'un rectangle, sont découpés.

FIG 1

FIG 2

FIG 3

FIG 4